**Europäisches Patentamt**

**European Patent Office**

**Office européen des brevets**

(19)

(11) Publication number: **0 111 599**
**B1**

(12) # EUROPEAN PATENT SPECIFICATION

(45) Date of publication of patent specification: **29.03.89**

(51) Int. Cl.⁴: **H 05 K 3/42,** H 05 K 3/00

(21) Application number: **82306625.3**

(22) Date of filing: **13.12.82**

(54) Method of processing through-holes.

(43) Date of publication of application:
**27.06.84 Bulletin 84/26**

(45) Publication of the grant of the patent:
**29.03.89 Bulletin 89/13**

(84) Designated Contracting States:
**DE FR GB**

(56) References cited:
**GB-A-1 094 447**
**US-A-3 977 075**
**US-A-4 183 137**

**ELEKTRONIK, vol. 28, no. 1, January 1979,
pages 63-66, DE. R. PIWERNETZ et al.: "Die
Einpresstechnik für Kontakte in gedruckte
Schaltungen (EKS)"**

**IBM TECHNICAL DISCLOSURE BULLETIN, vol.
20, no. 11A, April 1978, page 4306, New York,
USA. J.R. GETTEN: "PTH reliability using Sn-Bi
solder"**

(73) Proprietor: **LOMERSON, Robert Bogardus**
**Route 9, Box 196**
**Fort Worth, TX 76106 (US)**

(72) Inventor: **LOMERSON, Robert Bogardus**
**Route 9, Box 196**
**Fort Worth, TX 76106 (US)**

(74) Representative: **Murgitroyd, Ian G.**
**Murgitroyd and Company Mitchell House 333**
**Bath Street**
**Glasgow G2 4ER (GB)**

Courier Press, Leamington Spa, England.

EP 0111 599 B1

## Description

This invention relates to a method of simultaneously cleaning and conditioning the surface of a passage within a body, in particular through-holes in conductive and nonconductive materials.

## BACKGROUND OF THE INVENTION

In the prior art to produce a through-the hole conductive path in a printed circuit board having internal copper conductive layers as well as conductive layers of copper on both sides, the board, after lamination is first passed through a drilling operation where all the holes to be utilized as conductive holes through the board are drilled.

Thereafter a series of steps are taken in which debris, damage and resin smear created during the drilling operation are removed either mechanically, chemically or by gaseous plasma discharge in order to present a clean and acceptable surface for the subsequent deposition of a metallic coating.

Subsequently, a series of steps are taken in which a heavy layer of copper is ultimately deposited on the walls of each of the holes. This is done first subjecting it to a catalyst seeding operation wherein microdeposits of metal are placed on the walls of each of the holes. Thereafter, copper is plated onto the walls of the holes. After all of the holes have thus been plated, the printed circuit pattern is laid out on the two sides of the board and the copper is etched leaving the lead path intact. Finally the components are mounted on the circuit boards and a step which fills the holes containing the component leads with solder completes the task of securing the component to the board.

US-A-4 183 137 discloses a method which substantially improves on the foregoing prior art. In this method, the hole is formed by a cutting tool (eg a drill bit) which is passed through the material and into a metallic back-up plate. Operation of the tool is continued to cause metal from the back-up plate in finely subdivided form to be created which is forced into intimate contact with the wall of the hole to form a metallised layer thereon. Thus a metallised hole can be formed in essentially a single operation.

While the method of US-A-4 183 137 is a substantial improvement over the prior art, it has been found not to be suitable for all applications. The passage of the drill can create debris and can cause resin from the material to smear on the hole wall. The present invention, which is defined in Claim 1, is accordingly directed to a method which permits the cleaning and conditioning of the hole to remove debris and displace unwanted material.

A preferred feature of this invention relates to the reformable and reuseable nature of the back up material. Panels of masonite and other wood pulp materials are currently used to support the printed circuit board during drilling operation. These materials are rigid, not reformable and must be disposed of after use. Various low and intermediate melting alloys, waxes and plastics possess characteristics that make them ideally suited for use as a reformable back up plate for drilling and machining operations. Metallic alloys such as those discussed in US-A-4 183 137 are easily reformed by remelting and molding or extruding. Similarly waxes such as parafin, polyethylene and other rigid waxes perform this same function and can be further enhanced by the addition of a filler material such as Silica flour. The ability to reform a back up plate is a distinct advantage in itself since it requires only the addition of sufficient material to replace that lost as cuttings and the power to reform it. Reformable material has been successfully produced by extrusion, casting and molding.

## BRIEF DESCRIPTION OF THE DRAWINGS

The invention itself as well as further objects and advantages thereof will best be understood by reference to the following detailed description of illustrative embodiments taken in conjunction with the accompanying drawings in which:

Fig. 1 is a side view of a drill bit, panel of material and back-up plate.

Fig. 2 is a side view of a drill bit, a panel consisting of alternating layers of a conductive and nonconductive material and a back-up plate.

Fig. 3 is a top and edge view of a portable frame for receiving the reformable material.

## DETAILED DESCRIPTION

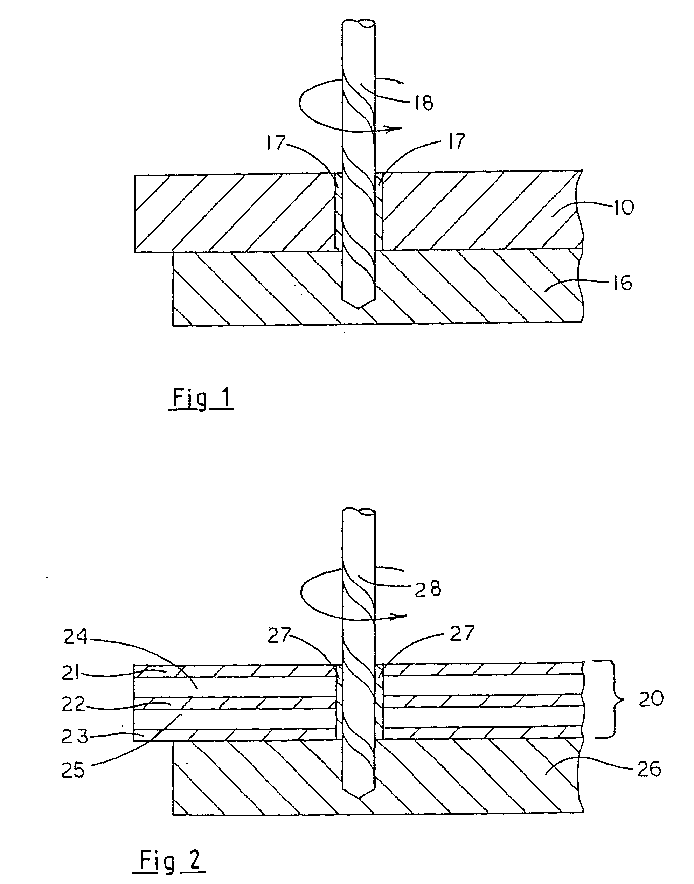

Referring now to Fig. 1, drill bit 18 passes through panel of material 10 and into back-up plate 16. Film 17 is generated from plate 16 by the turning action of drill bit 18 and is smeared onto the wall surface of the hole.

Referring now to fig. 2 drill bit 28 passes through a multilayer printed circuit board panel 20 consisting of conductive layers 21, 22 and 23 and insulating layers 24 and 25 and into back-up plate 26. Film 27 is generated from plate 26 by the turning action of drill bit 28 and is smeared onto the wall surface of the hole.

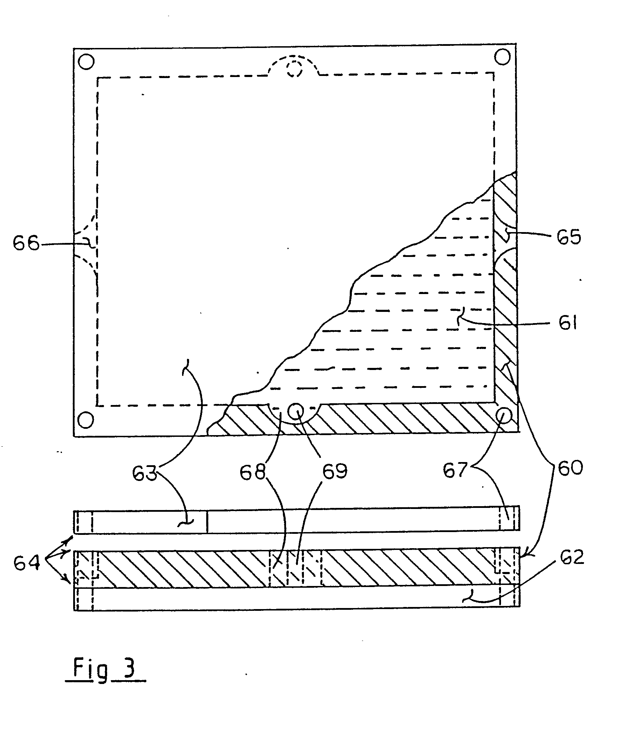

Referring now to Fig. 3, metal frame 60 is of sufficient size and thickness to retain and accommodate reformable material 61 that is poured or injected into frame 60. Bottom plate 62 and top plate 63 closely mate with frame 60 at border surface 64 to prevent excess remeltable material 61 from being extruded between plates 62, 63 and frame 60. Injection port 65 is located within frame 60 for the introduction of reformable material 61. Ejection port 66 is located within frame 60 for the elimination of excess reformable material 61. Top plate 63 is removable in order to expose surface of reformable material 61 for use as a back up plate for tooling operations such as drilling. Likewise, bottom plate 62 can also be removed to expose bottom surface of reformable material 61 in order to utilize both surfaces for back up purposes prior to reforming for subsequent use. Tooling holes 67 can be permanently located in frame 60 for precise mounting to tooling surfaces of equipment such as drill. Cut out area 68 is designed to accommodate secondary tooling holes 69 which are subsequently created in reformable material 61 as required to present a zero reference location for panels to be drilled.

In operation, referring to Fig. 1, the drill bit 18 is forced through the panel of material 10 and into back up plate 16. Upon contacting the plate of back-up material 16, the twisting, cutting action of the drill produces cuttings that are carried upwards by the turning drill bit 18. Film 17 is created as these cuttings are abraded against the surface of the hole wall. The shape and nature of these cuttings causes them to pack and come into intimate contact with the hole wall; rotational force causes these cuttings to abrade the surface of the hole wall thus removing loose drill damaged material and results in frictional melting of the cuttings at the interface. This molten material creates a film on the drill bit that reduces friction, prevents direct interfacing of the drill bit with the material to be drilled and cools the drill bit by the cooling action of the back-up plate and cuttings as they change from a solid to a liquid. Additionally, it is known that a large degree of heating of the drill bit occurs due to friction while it is within the back-up material. Heating of the drill bit above the melting point of the back-up material 16 cannot occur due to loss of friction as the back-up material 16 in contact with the drill bit 18 changes from a solid to a liquid state at the interface.

In the case where the panel of material 10 is an insulator, the use of a soft metal back-up plate 16 results in the smearing of a metallic film 17 onto the surface of the walls. This film is adherent and is subsequently removed by chemical or solvent action to present a smooth clean hole wall.

Similarly the use of a non-conductive back-up plate material results in the cleaning and deposition of a nonconductive film that is subsequently removed to present a smooth clean hole wall.

In the case where the panel of material 10 is metallic, the use of a soft metal back-up plate 16 results in the smearing of a metallic film 17 onto the surface of the walls. Again, this film is adherent and is subsequently removed by chemical or solvent action to present a smooth, clean hole wall. This in effect can create a plateable surface on an otherwise difficult to plate material such as aluminium.

Similarly, in fig. 2, the drill bit forces its way through alternating layers of conductive material 21, 22, 23 and nonconductive material 24, 25, in panel 20 and upon contacting the back-up plate 26 produces cuttings that are carried up the hole as previously described with similar results.

A particular problem encountered in the drilling of multilayer printed circuit boards is the occurrence of a film of resin that is smeared over the metal conductive layers by the heat and friction of the turning drill bit. This film is insulating and very tenaceous but must be removed in order that electrical contact can be made between these conductive layers and the subsequent plating that is to be deposited within the hole. The use of a metal back-up plate 26 effectively removes this resin smear and further coats the conductive layers with a layer of this metal film 27 that is subsequently removed by chemical or solvent action for further processing.

Similarly, the use of a non-conductive back-up plate material 26, also removes resin smear and is itself subsequently removed for further processing.

Referring to Fig. 3, frame 60 is placed between bottom plate 62 and top plate 63 and clamped so that a seal occurs between them at the border seal area 64. Reformable material 61 is poured, injected or otherwise introduced by the way of injection port 65 in such manner as to completely fill the cavity in frame 60 between plates 62 and 63. Entrapped air and excess reformable material 61 are forced out ejection port 66 by pressure of the incoming reformable material 61, by vacuum or a combination of both. In practice, upon cooling and solidification of the reformable material 61, top plate 63 is removed and frame 60 and bottom plate 62 are located on the drill table of the machine by means of tooling holes 67. Secondary tooling holes 69 are subsequently drilled in reformable material 61 in cut out areas 68 within frame for use as a zero reference for hole locations in the printed circuit boards that are to be drilled. Upon completion of the drilling operation, frame 60 and bottom plate 62 are removed. Frame 60 containing reformable material 61 may be reinstalled on the drill table as previously described in order to utilize the opposite face as a back-up plate. In some cases it may be advantageous to completely remove the plate of reformable material 61 from frame 60.

The surface of bottom plate 62 and top plate 63 facing frame 60 may be lined with foil to simplify removal of the frame from the plates. Further, either or both plates may be equipped for force cooling to prevent recrystallization or other undesired effects from occurring. Although the reformable material can be extruded in sheets, it is believed that the use of a frame as described above more suitably maintains the flatness and surface qualities desired in a back-up material.

## Claims

1. A method of simultaneously cleaning and conditioning the surface of a passage within a body (10) prior to plating by removing debris generated during a cutting operation and further displacing a deposited layer of smear material generated during said cutting operation, the method comprising:

   positioning a solid back-up plate (16) against said body (10),

   engaging a cutting tool (18) through said passage with the back-up plate,

   operating the cutting tool (18) to forcibly move mechanically spreadable cuttings in subdivided form from said back-up plate into intimate frictional contact with the surface of the passage to

create a film (17) displacing said debris and smear material, and

subsequently removing said film (17) by chemical or solvent action.

2. The method of claim I, in which the back-up plate (16) is of a re-formable and re-usable material.

3. The method of claim 2, in which the back-up plate (16) is of a re-meltable material.

**Patentansprüche**

1. Verfahren zum gleichzeitigen Reinigen und Konditionieren der Oberfläche eines innerhalb eines Körpers (10) befindlichen Durchlasses vor einem Plattiervorgang, durch Entfernen während einer Schneidoperation erzeugten Abriebs und ferner Verlagerung einer Ablagerungsschicht, die aus während der Schneidoperation erzeugtem Verschmiermaterial besteht, mit den folgenden Verfahrensschritten:

Ansetzen einer massiven Abstützplatte (16) gegen den Körper (10),

Einführen eines Schneidwerkzeugs (18) durch den Durchlaß in die Abstützplatte,

Betätigen des Schneidwerkzeugs (18), um mechanisch streubare Schneidpartikel in aufgeteilter Form zwangsläufig von der Abstützplatte in engen Reibkontakt mit der Oberfläche des Durchlasses zu bewegen, so daß ein Film (17) erzeugt wird, der den Abrieb und das Verschmiermaterial verlagert, und

anschließend Entfernen des Film (17) durch chemische oder Lösungsmittel-Wirkung.

2. Verfahren nach Anspruch 1, bei dem die Abstützplatte (16) aus einem rückformbaren und rückverwendbaren Material besteht.

3. Verfahren nach Anspruch 2, bei dem die Abstützplatte (16) aus einem rückschmelzbaren Material besteht.

**Revendications**

1. Procédé pour nettoyer et préparer simultanément la surface d'un passage à l'intérieur d'une pièce (10) préalablement à un placage, par enlèvement des débris engendrés pendant une opération de coupe, et en outre déplacement d'une couche déposée de salissure adhérente engendrée pendant ladite opération de coupe, le procédé comprenant:

l'application d'une contreplaque d'appui pleine (16) contre ladite pièce (10),

la mise en contact d'un outil de coupe (18) avec la contreplaque d'appui, à travers ledit passage;

la mise en service de l'outil de coupe (18) pour obliger des copeaux mécaniquement étalables et sous forme divisés, à se déplacer à partir de ladite contreplaque d'appui et en contact de friction intime avec la surface du passage, de manière à engendrer un film (17) qui déplace lesdits débris et ladite salissure adhérente, et

l'élimination subséquente dudit film (17) par l'action d'un réactif chimique ou d'un solvant.

2. Procédé suivant la revendication 1, dans lequel la contreplaque d'appui (16) est en une matière apte au reformage et à la réutilisation.

3. Procédé suivant la revendication 2, dans lequel la contreplaque d'appui (16) est en une matière qui peut être refondue.

Fig 1

Fig 2

Fig 3